# EUROPEAN PATENT SPECIFICATION

(11) **EP 4 722 626 B1**
(45) Date of publication and mention of the grant of the patent: **04.11.2026**
(21) Application number: 25203231.3
(22) Date of filing: 19.09.2025
(51) Int. Cl.: F28D 15/02, B23K 35/30, H05K 7/20, H10W 40/73, B23K 35/02, C22C 5/08

(54) **SILVER-COPPER ALLOY WELDING RING USED IN HEAT DISSIPATION DEVICES**
SILBER-KUPFER-LEGIERUNGSSCHWEISSRING ZUR VERWENDUNG IN WÄRMEABLEITUNGSVORRICHTUNGEN
ANNEAU DE SOUDAGE EN ALLIAGE ARGENT-CUIVRE UTILISÉ DANS DES DISPOSITIFS DE DISSIPATION DE CHALEUR

(30) Priority: 02.10.2024 US 202463702304 P
(43) Date of publication of application: 08.04.2026
(73) Proprietor: Purple Cloud Development Pte. Ltd., Singapore 128424 (SG)
(72) Inventor: LIU, Lei Lei, Hui Zhou City (CN); ZHANG, Xiong, Hui Zhou City (CN); HUANG, Jian-Jia, Taipei City (TW)
(74) Representative: Grünecker Patent- und Rechtsanwälte PartG mbB

(56) References cited:
- US-A1- 2020 370 837
- US-B2- 10 077 946
- US-B2- 10 126 069
- US-B2- 11 202 390

## Description

### TECHNICAL FIELD

The present disclosure relates to a welding ring, and more particularly to a welding ring made of a silver-copper alloy for use in heat dissipation devices.

### BACKGROUND

Conventionally, welding rings are primarily made of copper. However, copper has a relatively high melting point of approximately 1,084°C (1,983°F), which demands more energy during the welding process compared to materials with lower melting points. This increased energy for welding process is a challenge, including increasing manufacturing cost and increase the wear on welding equipment. Additionally, copper is readily oxidizing when exposed to air, particularly at increasing temperatures during welding. The resulting copper oxide layer on the surface acts as a barrier, which has an adverse effect on the weld quality by inhibiting proper fusion between components.

In heat dissipation devices, thermal conductivity is a critical factor for performance. Materials used must efficiently transfer heat away from sensitive components to maintain operational stability and prevent overheating. While copper offers high thermal conductivity, its limitations in weldability and oxidation resistance during fabrication can reduce overall manufacturing efficiency and reliability. Therefore, developing welding rings with improved material compositions that balance excellent thermal performance with enhanced weldability and oxidation resistance is essential for advancing heat dissipation technologies.

US-A-10077946 discloses a heat dissipation device according to the preamble of claim 1 and a heat conductive plate according to the preamble of claim 12.

### SUMMARY

The invention is as defined in the appended claims. In general terms, this disclosure is directed to a welding ring. In some embodiment, and by non-limiting examples, the present disclosure provides a silver-copper alloy welding ring specially designed for use in heat dissipation devices.

An aspect of the present disclosure provides a heat dissipation device. The heat dissipation device includes a plate body configured to be thermally coupled to a heat-generating element, a plate cover mounted to the plate body, the plate body and the plate cover together defining a vapor chamber, at least one internal wick structure disposed within the vapor chamber, a plurality of support columns disposed within the vapor chamber, and a plurality of heat pipes, each heat pipe extending through a corresponding through hole formed in the plate cover, wherein the heat pipe is bonded to the plate cover by soldering a welding ring at an interface between the heat pipe and the corresponding through hole, the welding ring comprising a silver-copper alloy containing about 66% to about 76% silver and about 24% to about 34% copper.

**In** one embodiment, the welding ring is sleeved on each of the plurality of heat pipes.

**In** one embodiment, the welding ring is soldered to secure and seal a junction between the heat pipe and the corresponding hole.

**In** one embodiment, the welding ring has a circular shape.

**In** one embodiment, the welding ring has an outer diameter ranging from 7.1 mm to 11.9 mm and an inner diameter ranging from 6.1 mm to 10.3 mm.

**In** one embodiment, the welding ring has an elliptical shape.

**In** one embodiment, the welding ring has a width between 8.55 mm and 15.05 mm, a thickness between 4.25 mm and 7.85 mm, and a corner radius between 1 mm and 3.5 mm.

**In** one embodiment, the welding ring has a rectangular shape.

**In** one embodiment, the welding ring has a width between 7.05 mm and 12.95 mm, a thickness between 4.25 mm and 7.85 mm, and a corner radius less than 1 mm.

**In** one embodiment, the silver-copper alloy has a eutectic composition.

**In** one embodiment, the silver-copper alloy comprises approximately 72 % silver and 28 % copper.

Another aspect of the present disclosure provides a heat conductive plate. The heat conductive plate includes a plate body configured to be thermally coupled to a heat-generating element, a plate cover mounted to the plate body, the plate cover and the plate body defining an enclosed internal chamber, at least one internal wick structure disposed within the enclosed internal chamber, a plurality of support columns disposed within the enclosed internal chamber; and a metallurgical bond formed between the plate cover and the plate body by soldering a welding paste, wherein the welding paste comprises a silver-copper alloy containing about 66% to about 76% silver and about 24% to about 34% copper.

In one embodiment, the welding paste is dispensed at an interface between the plate body and the plate cover via an injector.

In one embodiment, the metallurgical bond forms a hermetic seal around the enclosed internal chamber.

In one embodiment, the silver-copper alloy has a eutectic composition.

In one embodiment, the silver-copper alloy comprises approximately 72 % silver and 28 % copper.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is a graph illustrating a binary phase diagram of a silver-copper alloy.
FIG. 2 is a table illustrating theoretical melting point temperature for different silver-copper compositions.
FIGS. 3A-3D are graphs illustrating melting behavior of various silver-copper alloy compositions analyzed using differential scanning calorimetry (DSC).
FIG. 4 is a table illustrating the thermal conductivity coefficients of different silver-copper alloys based on their respective compositions.
FIG. 5 is a side view of a heat dissipation device in accordance with one embodiment of the present disclosure.
FIG. 6 is a side view of a heat conductive plate in accordance with another embodiment of the present disclosure.
FIG. 7A are tables illustrating specifications of welding rings having different shapes and sizes.
FIG. 7B illustrates three welding rings with circular cross-sectional shapes in different sizes.
FIG. 7C illustrates three welding rings with elliptical cross-sectional shapes in different sizes.
FIG. 7D illustrates three welding rings with rectangular cross-sectional shapes in different sizes.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

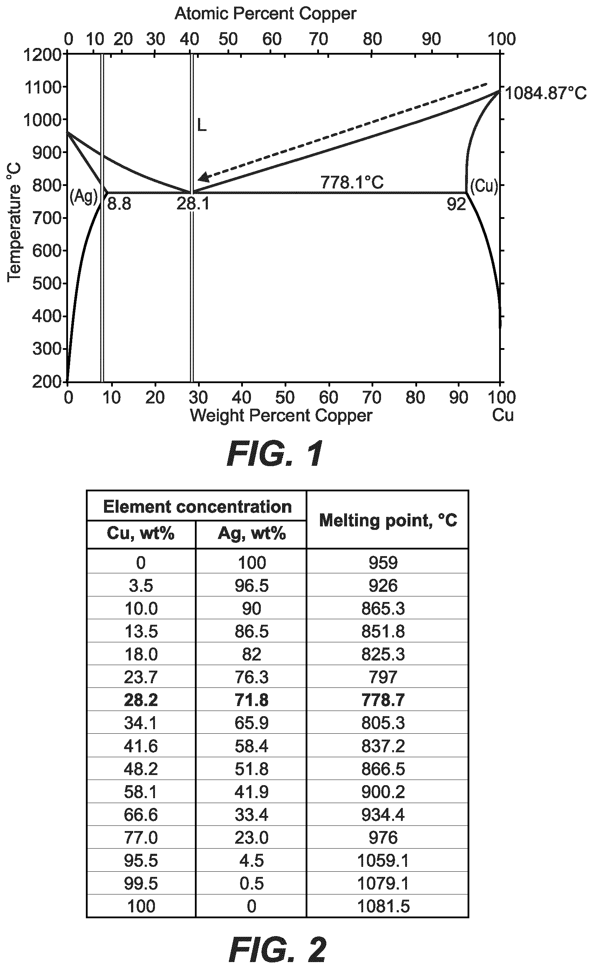

Referring to FIGS. 1-2. FIG. 1 is a graph illustrating a binary phase diagram of a silver-copper alloy. FIG. 2 is a table illustrating theoretical melting point temperature at different silver-copper compositions. As an example illustrated in FIG. 1, the diagram is plotted with temperature (°C) on the vertical axis and composition on the horizontal axis. The bottom horizontal axis represents the weight percent of copper, ranging from pure silver (0 wt% Cu) to pure copper (100 wt% Cu), and the top horizontal axis represents the corresponding atomic percent of copper.

As shown in FIG. 1, copper (Cu) and silver (Ag) form a eutectic system at a temperature of approximately 778°C. The eutectic composition occurs at approximately 28.2 wt% Cu and 71.8 wt% Ag. This represents the lowest melting point in the Ag-Cu alloy system. In comparison, pure Cu has a melting point of approximately 1081°C to 1084°C, while pure Ag melts at approximately 959°C. The data shown in FIG. 2 further confirms that the melting point of Cu gradually decreases with the addition of Ag. When the Ag-Cu alloy reaches the eutectic composition, its melting point significantly drops to 778.7°C, indicating the lowest temperature where the Ag-Cu alloy could become fully liquid.

The eutectic point is particularly important for designing welding rings in heat dissipation devices. By alloying copper with silver in a specific ratio, a welding material can achieve a significantly reduced melting temperature without sacrificing thermal conductivity. This allows for lower-temperature processing, reduces thermal stress on surrounding components, and minimizes oxidation issues commonly associated with high-temperature copper welding. Therefore, the silver-copper alloy at or near the eutectic composition offers an optimal balance between performance and manufacturability in high-efficiency thermal applications.

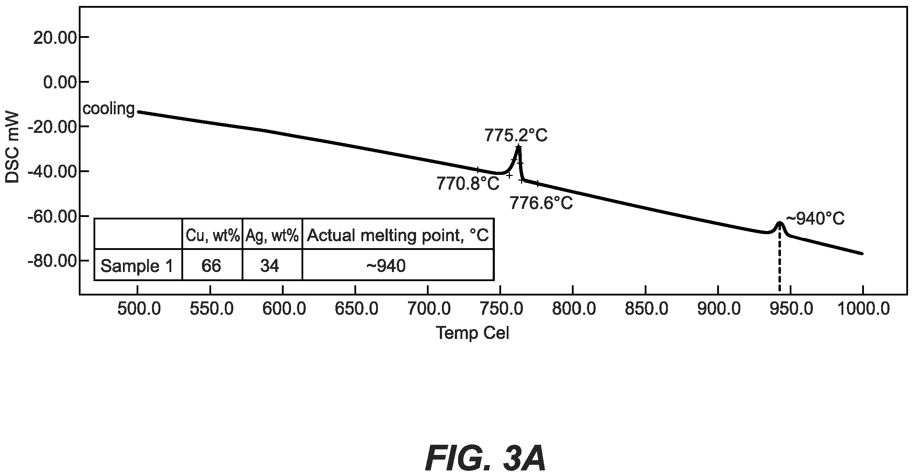

Referring to FIGS. 3A-3D. FIGS. 3A-3D are graphs illustrating melting behavior of various silver-copper alloy compositions analyzed using differential scanning calorimetry (DSC). In FIGS. 3A-3D, the horizontal axis represents temperature (°C), showing the temperature range over which the sample was heated or cooled during the DSC analysis, and the vertical axis represents heat flow (mw), indicating the heat absorbed or released by the sample as a function of temperature. The DSC results were used to determine the onset of melting (solidus temperature) and the completion of melting (liquidus temperature). For purposes of this disclosure, the "melting point" refers to the liquidus temperature.

In FIG. 3A, the alloy sample 1 contains 66 wt% Cu and 34 wt% Ag. The solidus temperature is observed at approximately 775.2°C, and the liquidus temperature is approximately 940°C. These results indicate that a higher copper content correlates with a greater melting range.

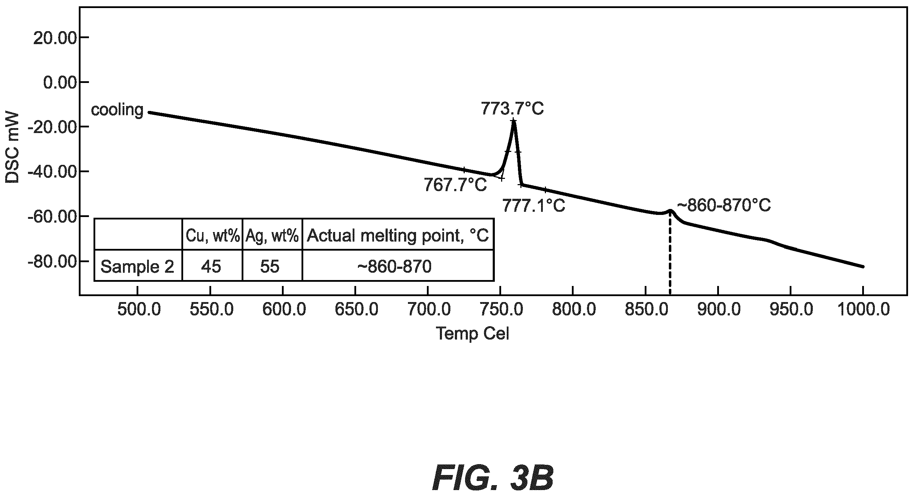

In FIG. 3B, the alloy sample 2 contains 45 wt% Cu and 55 wt% Ag. The solidus temperature occurs at approximately 773.7°C, and the liquidus temperature ranges from approximately 860°C to 870°C. The decrease in both solidus and liquidus temperatures compared to FIG. 3A reflects the effect of increased silver content in lowering the melting range.

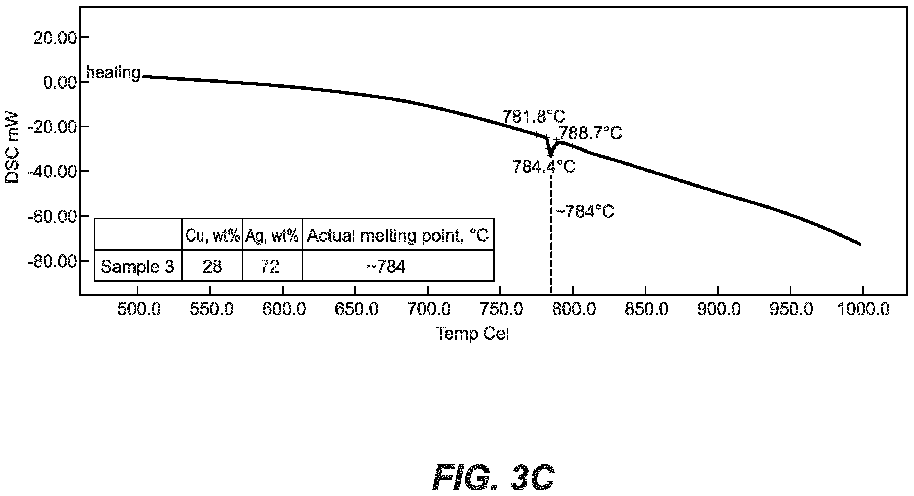

In FIG. 3C, the alloy sample 3 contains 28 wt% Cu and 72 wt% Ag. Both the solidus and liquidus temperatures occur at approximately 784°C. This indicates a eutectic composition, where the alloy exhibits a sharp, single melting point. A eutectic point is defined as the specific composition in a binary alloy system at which the constituents melt or solidify simultaneously at a single, lowest possible temperature, forming a fine, uniform microstructure upon solidification. The eutectic alloy does not exhibit a melting range but transitions directly from solid to liquid at the eutectic temperature

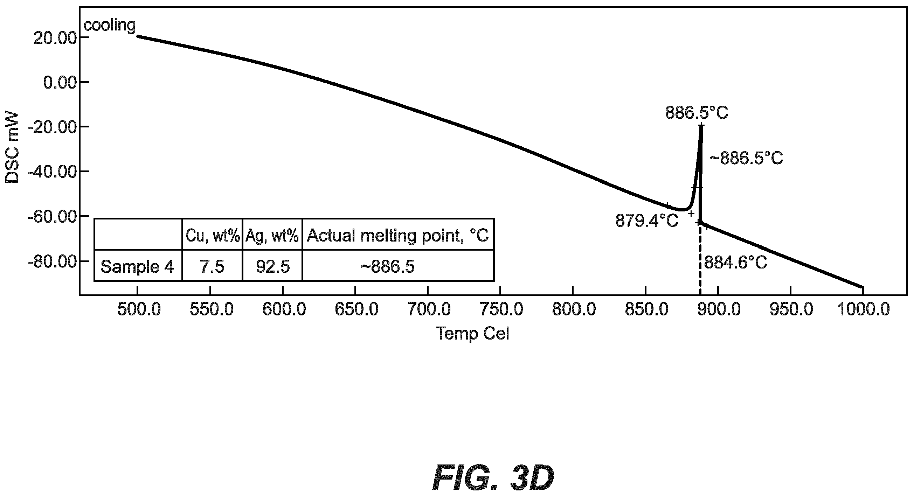

In FIG. 3D, the alloy sample 4 contains 7.5 wt% Cu and 92.5 wt% Ag. Both the solidus and liquidus temperatures are observed at approximately 886.5°C. The data shows that increasing silver content beyond the eutectic composition elevates the melting point.

Accordingly, the melting behavior of Ag-Cu alloys is contingent upon their composition. As silver content increases, the melting temperature decreases, attaining a minimum at the eutectic composition of 28 wt% Cu and 72 wt% Ag. Beyond this eutectic point, further addition of silver elevates melting temperature. The eutectic alloy (Sample 3) presents the most favorable melting characteristics for low-temperature soldering applications while maintaining commendable thermal conductivity.

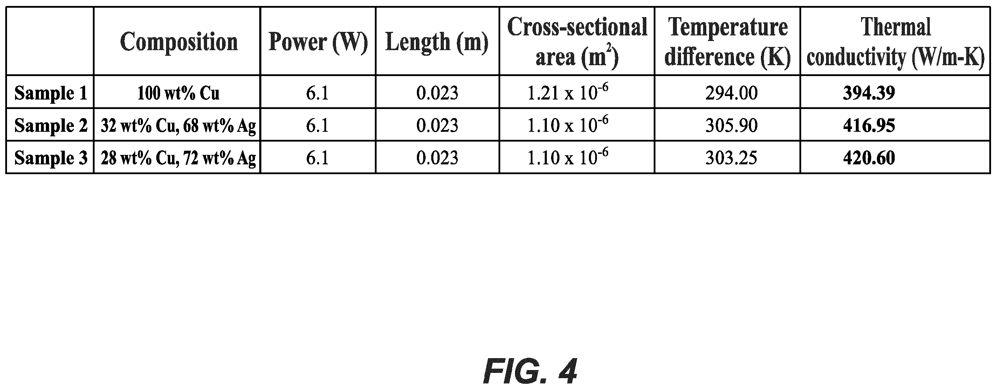

Referring to FIG. 4. FIG. 4 is a table illustrating the thermal conductivity coefficients of different silver-copper alloys based on their respective compositions. The table in FIG. 4 is a summary of experimental results obtained through the steady-state method, which was employed to determine how the thermal conductivity coefficient (K) is contingent upon different silver-to-copper ratios.

The thermal conductivity coefficient (K) was measured using the steady-state method. In the steady-state method, each sample was arranged with one end in thermal contact with a heat source and the opposite end with a heat sink, thereby assuring a unidirectional and stable heat flow. Thermocouples were attached to both ends of the sample to measure the temperature differential (ΔT = T1 - T2) once thermal equilibrium was established. The thermal conductivity coefficient was then calculated using the formula: $K = \frac{Q \times L}{A \times ΔT}$, where K is the thermal conductivity coefficient (W/m·K), Q is the Power input (W), L is the Length of the sample (m), A is the Cross-sectional area (m²), and ΔT is the Temperature difference (K) across the sample.

As shown in FIG. 4, the thermal conductivity coefficient for pure copper (Sample 1) was measured at 394.39 \W/m·K. Upon the introduction of silver into the alloy, the thermal conductivity improved notably. Sample 2, with a moderate silver content, exhibited a conductivity of 416.95 W/m·K, while Sample 3, containing 72 wt% Ag and 28 wt% Cu, achieved the highest conductivity of 420.60 W/m·K among all samples tested. These results demonstrate that increasing the silver content in a copper-based alloy leads to an improvement in thermal conductivity. The observed trend indicates that Ag-Cu alloys with the composition of approximately 72 wt% Ag and approximately 28 wt% Cu exhibit enhanced heat dissipation performance, making them highly appropriate for high-performance soldering and thermal management applications.

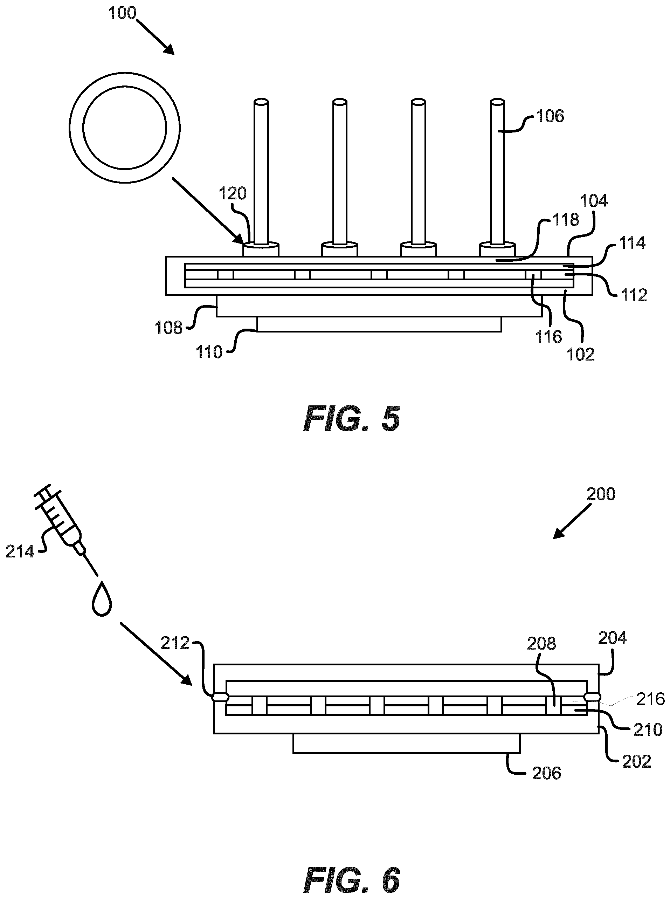

Referring to FIG. 5. FIG. 5 is a side view of a heat dissipation device in accordance with one embodiment of the present disclosure. As an example illustrated in FIG. 5, the heat dissipation device includes a plate body 102, a plate cover 104, and a plurality of heat pipes 106.

In one embodiment, a first protrusion structure 108 extends from the plate body 102 in a direction away from the plate cover 104. A second protrusion structure 110 further extends from the first protrusion structure 108 in the same direction. The second protrusion structure 110 is configured to make direct thermal contact with a heat-generating component (not shown), such as a central processing unit (CPU), graphics processing unit (GPU), or similar electronic device. Accordingly, heat generated by the component flows through the second protrusion structure 110 and the first protrusion structure 108 into the plate body 102, thereby thermally coupling the plate body 102 to the heat-generating element.

In one embodiment, the plate cover 104 is secured to the plate body 102 to form a sealed vapor chamber 112. At least one internal wick structure 114 is disposed inside the vapor chamber 112 to facilitate capillary return of condensed working fluid. A plurality of support columns 116 are also positioned within the vapor chamber 112 to maintain the structural integrity of the chamber under the circumstances of vacuum or thermal stress.

In one embodiment, each of the heat pipes 106 extends through a corresponding through hole 118 located in the plate cover 104. Each heat pipe 106 is bonded to the plate cover 104 by soldering a welding ring 120 that is sleeved on the heat pipe 106 and positioned at an interface between each heat pipe 106 and the corresponding through hole 118. The soldered welding ring 120 secures and seals a junction between the heat pipe 106 and the corresponding through hole 118. In some embodiments, the welding ring 120 comprises a silver-copper alloy containing approximately 66 wt% to 76 wt% silver and 24 wt% to 34 wt% copper. In one embodiment, the silver-copper alloy has a eutectic composition of about 72 wt% silver and 28 wt% copper. As previously indicated, the eutectic composition provides a low and sharp melting point, allowing for reliable and uniform bonding with minimal thermal stress during the welding process. The welding ring 120 is configured to metallurgically bond the heat pipe 106 to the plate cover 104, thereby establishing a hermetic seal around the heat pipe 106 and ensuring effective thermal conduction between the heat pipe 106 and the vapor chamber 112.

As an example illustrated in FIG. 5, the welding ring 120 has a circular shape. However, the embodiment is not limited thereto. In other embodiments, the welding ring may have an elliptical, rectangular, or any other shape suitable for forming a secure and thermally conductive seal between the heat pipe 106 and the corresponding through hole 118. The specification of the welding ring with different specification will be discussed later.

Referring to FIG. 6. FIG. 6 is a side view of a heat conductive plate in accordance with another embodiment of the present disclosure. As an example illustrated in FIG. 6, the heat conductive plate 200 includes a plate body 202 and a plate cover 204. The plate cover 204 is configured to couple with the plate body 202 to define an enclosed internal chamber 216.

In one embodiment, a protrusion structure 206 extends from the plate body 202 in a direction away from the plate cover 204. The protrusion structure 206 is configured to make direct thermal contact with a heat-generating component (not shown), such as a central processing unit (CPU), graphics processing unit (GPU), or similar electronic device. Accordingly, heat generated by the component flows through the protrusion structure 206 into the plate body 202, thereby thermally coupling the plate body 202 to the heat-generating element.

In one embodiment, at least one internal wick structure 210 is disposed inside the enclosed internal chamber 216 to facilitate capillary return of condensed working fluid. A plurality of support columns 208 are also positioned inside the enclosed internal chamber 216 to maintain structural integrity under vacuum conditions and to prevent mechanical deformation caused by thermal cycling.

In one embodiment, a metallurgical bond (not shown) is formed between the plate cover 204 and the plate body 202 by soldering a welding paste 212, which is dispensed at the interface between the plate body 202 and the plate cover 204 via an injector 214. This metallurgical bond forms a hermetic seal around the internal chamber, preventing working fluid leakage and ensuring internal pressure stability while in operation. In some embodiments, the welding paste 212 comprises a silver-copper alloy containing approximately 66 wt% to 76 wt% silver and 24 wt% to 34 wt% copper. In one embodiment, the silver-copper alloy has a eutectic composition of about 72 wt% silver and 28 wt% copper. As previously indicated, the eutectic composition provides a low and sharp melting point, allowing for reliable and consistent bonding with minimal thermal stress during the welding process.

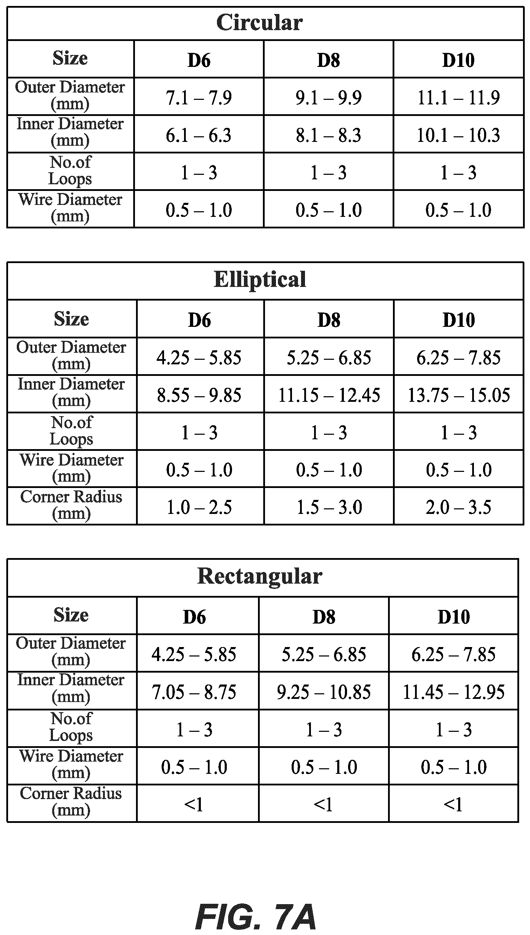

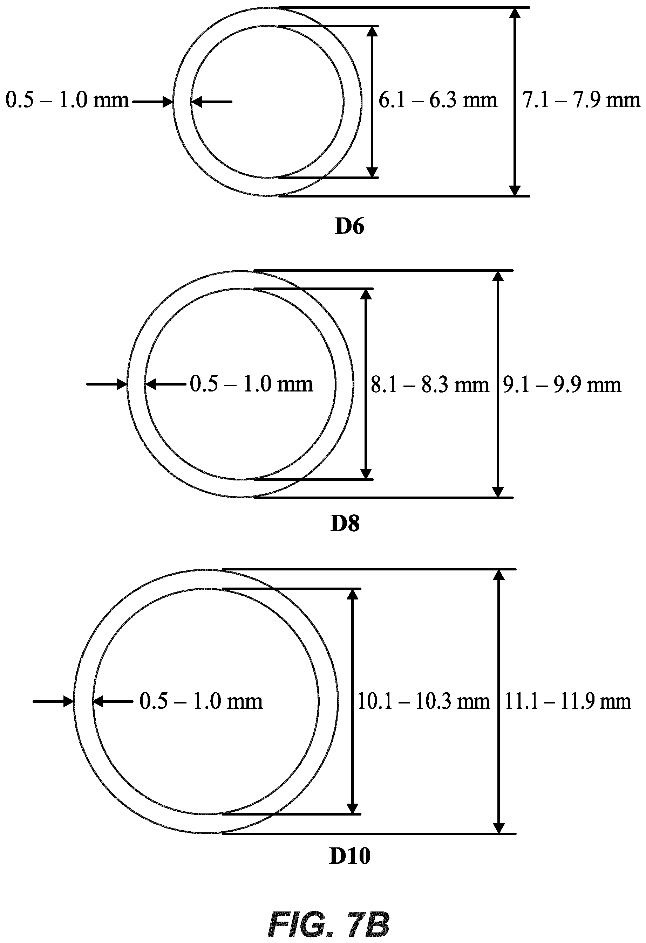

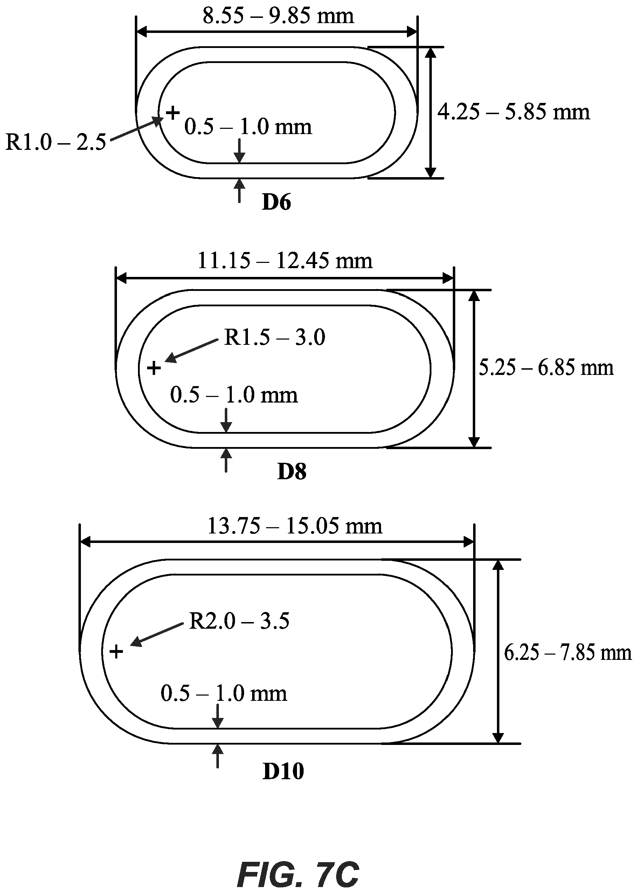

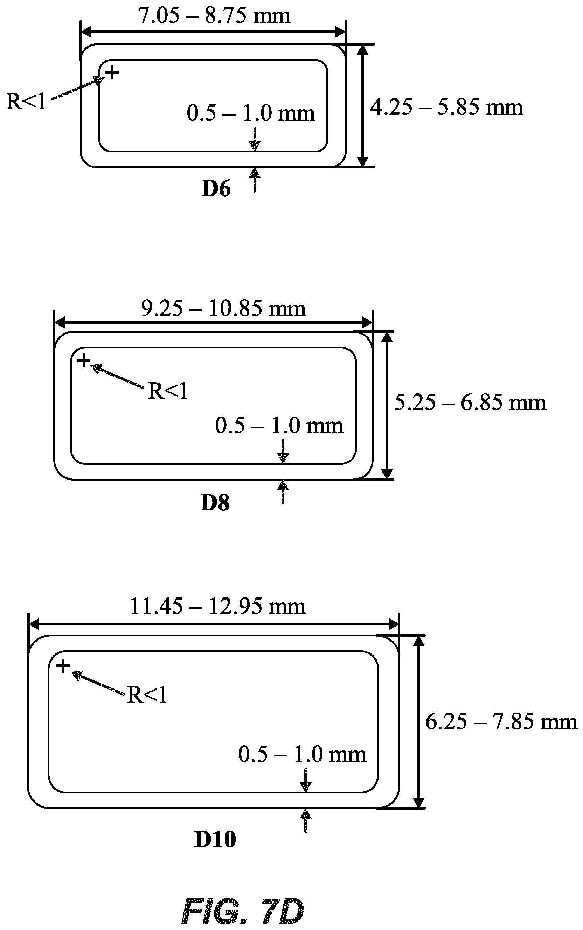

Referring to FIGS. 7A-7D. FIG. 7A are tables illustrating specifications of welding rings having different shapes and sizes. FIG. 7B illustrates three welding rings with circular cross-sectional shapes in different sizes. FIG. 7C illustrates three welding rings with elliptical cross-sectional shapes in different sizes. FIG. 7D illustrates three welding rings with rectangular cross-sectional shapes in different sizes. As shown in FIG. 7A, the table divides the welding rings into three categories depending on their seal cross-sectional geometries: circular, elliptical, and rectangular. Each category is further subdivided into three size variants: D6, D8, and D10.

In FIG. 7B, the circular welding rings have outer diameters ranging from 7.1 mm to 11.9 mm and inner diameters ranging from 6.1 mm to 10.3 mm. In FIG. 7C, the elliptical welding rings have widths between 8.55 mm and 15.05 mm, thicknesses between 4.25 mm and 7.85 mm, and corner radii ranging from 1 mm to 3.5 mm. In FIG. 7D, the rectangular welding rings have widths between 7.05 mm and 12.95 mm, thicknesses between 4.25 mm and 7.85 mm, and corner radii of less than 1 mm.

The availability of welding rings in diverse shapes and sizes facilitate adaptable integration with varied interface geometries between heat pipes and the plate body. By selecting an appropriate shape and size based on structural and thermal design requirements, the welding rings can improve mechanical stability and promote sealing performance throughout the soldering process. This enhances reliability and thermal efficiency of the integrated heat transfer system.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the scope of the claims.

## Claims

1. A heat dissipation device, comprising:
a plate body (102) configured to be thermally coupled to a heat-generating element;
a plate cover (104) mounted to the plate body (102), the plate body (102) and the plate cover (104) together defining a vapor chamber (112);
at least one internal wick structure (114) disposed within the vapor chamber (112); and
a plurality of heat pipes (106), each heat pipe (106) extending through a corresponding through hole (118) formed in the plate cover (104), wherein the heat pipe (106) is bonded to the plate cover (104) by soldering a welding ring (120) at an interface between the heat pipe (106) and the corresponding through hole (118), **characterised in that** a plurality of support columns (116) are disposed within the vapor chamber (112) and the welding ring (120) comprises a silver-copper alloy containing about 66% to about 76% silver and about 24% to about 34% copper.

2. The heat dissipation device of claim 1, wherein the welding ring (120) is sleeved on each of the plurality of heat pipes (106).

3. The heat dissipation device of claim 1, wherein the welding ring (120) is soldered to secure and seal a junction between the heat pipe (106) and the corresponding hole (118).

4. The heat dissipation device of claim 1, wherein the welding ring (120) has a circular shape.

5. The heat dissipation device of claim 4, wherein the welding ring (120) has an outer diameter ranging from 7.1 mm to 11.9 mm and an inner diameter ranging from 6.1 mm to 10.3 mm.

6. The heat dissipation device of claim 1, wherein the welding ring (120) has an elliptical shape.

7. The heat dissipation device of claim 6, wherein the welding ring (120) has a width between 8.55 mm and 15.05 mm, a thickness between 4.25 mm and 7.85 mm, and a corner radius between 1 mm and 3.5 mm.

8. The heat dissipation device of claim 1, wherein the welding ring (120) has a rectangular shape.

9. The heat dissipation device of claim 8, wherein the welding ring (120) has a width between 7.05 mm and 12.95 mm, a thickness between 4.25 mm and 7.85 mm, and a corner radius less than 1 mm.

10. The heat dissipation device of claim 1, wherein the silver-copper alloy has a eutectic composition.

11. The heat dissipation device of claim 1, wherein the silver-copper alloy comprises approximately 72% silver and 28% copper.

12. A heat conductive plate, comprising:
a plate body (202) configured to be thermally coupled to a heat-generating element;
at least one internal wick structure (210) disposed within an enclosed internal chamber (112); **characterised in that** the enclosed internal chamber (112) is defined by a plate cover (204) mounted to the plate body (202);
a plurality of support columns (208) are disposed within the enclosed internal chamber (112)
and
a metallurgical bond is formed between the plate cover (204) and the plate body (202) by soldering a welding paste (212), wherein the welding paste (212) comprises a silver-copper alloy containing about 66% to about 76% silver and about 24% to about 34% copper.

13. The heat conductive plate of claim 12, wherein the welding paste (212) is dispensed at an interface between the plate body (202) and the plate cover (204) via an injector (214).

14. The heat conductive plate of claim 12, wherein the metallurgical bond forms a hermetic seal around the enclosed internal chamber (112).

15. The heat conductive plate of claim 12, wherein the silver-copper alloy has a eutectic composition.

16. The heat conductive plate of claim 12, wherein the silver-copper alloy comprises approximately 72% silver and 28% copper.

## Patentansprüche

1. Eine Wärmeableitvorrichtung, umfassend:
einen Plattenkörper (102), der so konfiguriert ist, dass er thermisch mit einem wärmeerzeugenden Element gekoppelt ist;
eine Plattenabdeckung (104), die an dem Plattenkörper (102) angebracht ist, wobei der Plattenkörper (102) und die Plattenabdeckung (104) gemeinsam eine Dampfkammer (112) bilden;
mindestens eine innere Dochtstruktur (114), die innerhalb der Dampfkammer (112) angeordnet ist;
und
eine Vielzahl von Wärmerohren (106), wobei sich jedes Wärmerohr (106) durch ein übereinstimmendes, in der Plattenabdeckung (104) ausgebildetes Durchgangsloch (118) erstreckt, wobei das Wärmerohr (106) durch Löten eines Schweißrings (120) an einer Grenzfläche zwischen dem Wärmerohr (106) und dem entsprechenden Durchgangsloch (118) durch Löten eines Schweißrings (120) an der Grenzfläche zwischen dem Wärmerohr (106) und der entsprechenden Durchgangsbohrung mit der Plattenabdeckung (104) verbunden ist,
**dadurch gekennzeichnet, dass** eine Vielzahl von Stützsäulen (116) innerhalb der Dampfkammer (112) angeordnet ist und der Schweißring (120) eine Silber-Kupfer-Legierung umfasst, die etwa 66 % bis etwa 76 % Silber und etwa 24 % bis etwa 34 % Kupfer enthält.

2. Die Wärmeableitvorrichtung nach Anspruch 1, wobei der Schweißring (120) auf jedes der mehrere Wärmerohre (106) aufgeschoben ist.

3. Die Wärmeableitvorrichtung nach Anspruch 1, wobei der Schweißring (120) angelötet ist, um eine Verbindung zwischen dem Wärmerohr (106) und der übereinstimmenden Bohrung (118) zu sichern und abzudichten.

4. Die Wärmeableitvorrichtung nach Anspruch 1, wobei der Schweißring (120) eine kreisförmige Gestalt aufweist.

5. Die Wärmeableitvorrichtung nach Anspruch 4, wobei der Schweißring (120) einen Außendurchmesser im Bereich von 7,1 mm bis 11,9 mm und einen Innendurchmesser im Bereich von 6,1 mm bis 10,3 mm aufweist.

6. Die Wärmeableitvorrichtung nach Anspruch 1, wobei der Schweißring (120) eine elliptische Form aufweist.

7. Die Wärmeableitvorrichtung nach Anspruch 6, wobei der Schweißring (120) eine Breite zwischen 8,55 mm und 15,05 mm, eine Dicke zwischen 4,25 mm und 7,85 mm und einen Eckenradius zwischen 1 mm und 3,5 mm aufweist.

8. Die Wärmeableitvorrichtung nach Anspruch 1, wobei der Schweißring (120) eine rechteckige Form aufweist.

9. Die Wärmeableitvorrichtung nach Anspruch 8, wobei der Schweißring (120) eine Breite zwischen 7,05 mm und 12,95 mm, eine Dicke zwischen 4,25 mm und 7,85 mm und einen Eckenradius von weniger als 1 mm aufweist.

10. Die Wärmeableitvorrichtung nach Anspruch 1, wobei die Silber-Kupfer-Legierung eine eutektische Zusammensetzung aufweist.

11. Die Wärmeableitvorrichtung nach Anspruch 1, wobei die Silber-Kupfer-Legierung etwa 72 % Silber und 28 % Kupfer umfasst.

12. Eine Wärmeübertragungsplatte, umfassend:
einen Plattenkörper (202), der so konfiguriert ist, dass er thermisch mit einem wärmeerzeugenden Element gekoppelt ist;
mindestens eine innere Dochtstruktur (210), die innerhalb einer umschlossenen Innenkammer (112) angeordnet ist;
**dadurch gekennzeichnet, dass** die geschlossene Innenkammer (112) durch eine am Plattenkörper (202) befestigte Plattenabdeckung (204) begrenzt ist, wobei mehrere Stützsäulen (208) innerhalb der geschlossenen Innenkammer (112) angeordnet sind; und
zwischen der Plattenabdeckung (204) und dem Plattenkörper (202) durch Löten einer Lötpaste (212) eine metallurgische Verbindung hergestellt ist, wobei die Lötpaste (212) eine Silber-Kupfer-Legierung umfasst, die etwa 66 % bis etwa 76 % Silber und etwa 24 % bis etwa 34 % Kupfer enthält.

13. Die Wärmeübertragungsplatte nach Anspruch 12, wobei die Schweißpaste (212) über eine Einspritzdüse (214) an einer Grenzfläche zwischen dem Plattenkörper (202) und der Plattenabdeckung (204) aufgebracht wird.

14. Die Wärmeübertragungsplatte nach Anspruch 12, wobei die metallurgische Verbindung eine hermetische Abdichtung um die umschlossene Innenkammer (112) herum bildet.

15. Die Wärmeübertragungsplatte nach Anspruch 12, wobei die Silber-Kupfer-Legierung eine eutektische Zusammensetzung aufweist.

16. Die Wärmeübertragungsplatte nach Anspruch 12, wobei die Silber-Kupfer-Legierung etwa 72 % Silber und 28 % Kupfer umfasst.

## Revendications

1. Dispositif de dissipation de chaleur, comprenant :
un corps de plaque (102) configuré pour être couplé thermiquement à un élément de génération de chaleur ;
un couvercle de plaque (104) monté sur le corps de plaque (102), le corps de plaque (102) et le couvercle de plaque (104) définissant conjointement une chambre à vapeur (112) ;
au moins une structure de mèche interne (114) disposée à l'intérieur de la chambre à vapeur (112) ;
une pluralité de caloducs (106), chaque caloduc (106) s'étendant à travers un trou traversant correspondant (118) formé dans le couvercle de plaque (104), dans lequel le caloduc (106) est assemblé au couvercle de plaque (104) par brasage d'un anneau de soudage (120) à une interface entre le caloduc (106) et le trou traversant correspondant (118),
**caractérisé en ce qu'**une pluralité de colonnes de support (116) est disposée à l'intérieur de la chambre à vapeur (112) et **en ce que** l'anneau de soudage (120) comprend un alliage argent-cuivre contenant d'environ 66 % à environ 76 % d'argent et d'environ 24 % à environ 34 % de cuivre.

2. Dispositif de dissipation de chaleur selon la revendication 1, dans lequel l'anneau de soudage (120) est manchonné sur chaque caloduc de la pluralité de caloducs (106).

3. Dispositif de dissipation de chaleur selon la revendication 1, dans lequel l'anneau de soudage (120) est brasé pour fixer et sceller une jonction entre le caloduc (106) et le trou correspondant (118).

4. Dispositif de dissipation de chaleur selon la revendication 1, dans lequel l'anneau de soudage (120) présente une forme circulaire.

5. Dispositif de dissipation de chaleur selon la revendication 4, dans lequel l'anneau de soudage (120) présente un diamètre externe compris entre 7,1 mm et 11,9 mm et un diamètre interne compris entre 6,1 mm et 10,3 mm.

6. Dispositif de dissipation de chaleur selon la revendication 1, dans lequel l'anneau de soudage (120) présente une forme elliptique.

7. Dispositif de dissipation de chaleur selon la revendication 6, dans lequel l'anneau de soudage (120) présente une largeur comprise entre 8,55 mm et 15,05 mm, une épaisseur comprise entre 4,25 mm et 7,85 mm, et un rayon de coin compris entre 1 mm et 3,5 mm.

8. Dispositif de dissipation de chaleur selon la revendication 1, dans lequel l'anneau de soudage (120) présente une forme rectangulaire.

9. Dispositif de dissipation de chaleur selon la revendication 8, dans lequel l'anneau de soudage (120) présente une largeur comprise entre 7,05 mm et 12,95 mm, une épaisseur comprise entre 4,25 mm et 7,85 mm, et un rayon de coin inférieur à 1 mm.

10. Dispositif de dissipation de chaleur selon la revendication 1, dans lequel l'alliage argent-cuivre a une composition eutectique.

11. Dispositif de dissipation de chaleur selon la revendication 1, dans lequel l'alliage argent-cuivre comprend environ 72 % d'argent et 28 % de cuivre.

12. Plaque conductrice de chaleur, comprenant :
un corps de plaque (202) configuré pour être couplé thermiquement à un élément de génération de chaleur ;
au moins une structure de mèche interne (210) disposée à l'intérieur d'une chambre interne enfermée (112) ;
**caractérisée en ce que**
la chambre interne enfermée (112) est définie par un couvercle de plaque (204) monté sur le corps de plaque (202) ;
une pluralité de colonnes de support (208) est disposée à l'intérieur de la chambre interne enfermée (112) ; et
un assemblage métallurgique est formé entre le couvercle de plaque (204) et le corps de plaque (202) par brasage d'une pâte à braser (212), dans laquelle la pâte à braser (212) comprend un alliage argent-cuivre contenant d'environ 66 % à environ 76 % d'argent et d'environ 24 % à environ 34 % de cuivre.

13. Plaque conductrice de chaleur selon la revendication 12, dans laquelle la pâte à braser (212) est distribuée à une interface entre le corps de plaque (202) et le couvercle de plaque (204) via un injecteur (214).

14. Plaque conductrice de chaleur selon la revendication 12, dans laquelle l'assemblage métallurgique forme un joint hermétique autour de la chambre interne enfermée (112).

15. Plaque conductrice de chaleur selon la revendication 12, dans laquelle l'alliage argent-cuivre a une composition eutectique.

16. Plaque conductrice de chaleur selon la revendication 12, dans laquelle l'alliage argent-cuivre comprend environ 72 % d'argent et 28 % de cuivre.
